# DEMANDE DE BREVET EUROPEEN

(11) **EP 0 858 179 A1**
(43) Date de publication de la demande: **12.08.1998**
(21) Numéro de dépôt: 98400274.1
(22) Date de dépôt: 09.02.1998
(51) Int. Cl.: H04J 1/05, H03D 7/16

(54) **Extraction et transposition en bande de base numériques d'un canal d'un multiplex fréquentiel**

(30) Priorité: 10.02.1997 FR 9701477
(71) Demandeur: ALCATEL ALSTHOM COMPAGNIE GENERALE D'ELECTRICITE, 75008 Paris (FR)
(72) Inventeur: Bertrand, Cyril, 75018 Paris (FR); Sehier, Philippe, 78100 St Germain en Laye (FR)
(74) Mandataire: Scheer, Luc

(57) **Abrégé**

L'invention concerne un dispositif de filtrage, décimation et transposition en bande de base, du type entièrement numérique, permettant d'une part d'extraire et de transposer en bande de base l'un des canaux, dit canal d'intérêt, d'un multiplex fréquentiel de canaux, et d'autre part de réduire le facteur de suréchantillonnage dudit canal d'intérêt, chaque canal étant associé à une porteuse distincte. Ce dispositif comprend au moins deux étages en cascade (40₁ à 40_{L}), chaque étage comprenant des moyens (42) de filtrage et des moyens (43) de décimation, lesdits moyens de filtrage étant placés en amont desdits moyens de décimation et permettant d'épurer une partie du spectre aux endroits où les moyens de décimation produisent des repliements de spectre.

Selon l'invention, chaque étage (40₁ à à 40_{L}) comprend en outre des moyens (41) de transposition, placés en amont desdits moyens (42) de filtrage et associés à une fréquence de transposition (f_{t,i}), choisie préalablement parmi un jeu de N fréquences de transposition distinctes possibles, de façon à transposer au plus près de la fréquence nulle la porteuse (p₀) associée audit canal d'intérêt.

## Description

Le domaine de l'invention est celui des transmissions de données, et en particulier celles du type à accès multiple à répartition en fréquence (AMRF, ou FDMA pour "Frequency Division Multiple Access" en langue anglaise), consistant à émettre un multiplex fréquentiel de canaux.

D'une façon générale, chaque canal du multiplex est associé à une fréquence porteuse et à un débit. Dans le cas présent, la fréquence porteuse et le débit de chaque canal sont absolument quelconques.

Plus précisément, l'invention concerne un dispositif et un procédé numériques de filtrage, décimation et transposition en bande de base d'un canal particulier d'un multiplex fréquentiel. En d'autres termes, la présente invention concerne un dispositif et un procédé permettant d'extraire et de transposer en bande de base un canal particulier, dit canal d'intérêt, d'un multiplex fréquentiel de canaux, et de réduire le facteur de suréchantillonnage de ce canal d'intérêt.

De façon classique, les opérations de filtrage, décimation et transposition sont mises en oeuvre dans un démodulateur capable de recevoir un multiplex fréquentiel, et précèdent d'autres opérations, telles que notamment des opérations de filtrage-réception, d'interpolation, de synchronisation, de décodage, etc.

Egalement de façon classique, on suppose dans la suite de la description que le multiplex fréquentiel a préalablement été transposé en fréquence intermédiaire ou bien se trouve déjà en bande de base. On rappelle que le fait que le multiplex se trouve en bande de base ne signifie en aucune façon que le canal d'intérêt compris dans ce multiplex se trouve lui aussi en bande de base. Par conséquent, il est clair que l'invention (qui vise notamment à ramener en bande de base le canal d'intérêt) s'applique dans les deux cas précités.

La présente invention concerne uniquement des traitements (filtrage, décimation et transposition) de type numérique. En effet, de façon à profiter au maximum des avantages liés au numérique (reproductibilité, précision, souplesse des règles de conception, ...), on cherche à réaliser de façon entièrement numérique certaines tâches traditionnellement dévolues au domaine analogique.

Ceci signifie donc que le multiplex fréquentiel a préalablement été numérisé (échantillonnage et conversion analogique/numérique) de façon globale. En d'autres termes, l'ensemble du multiplex fréquentiel a été échantillonné à une cadence qui, du fait que la bande est encore complète, est relativement élevée (par exemple à une fréquence d'échantillonnage comprise entre 40 et 60 MHz).

Comme le canal d'intérêt (à extraire et transposer en bande de base) est de faible largeur devant la fréquence d'échantillonnage, il convient de réduire le suréchantillonnage de ce canal d'intérêt à une valeur modérée (4 à 8 échantillons par symbole, par exemple). Pour mention, les débits traités varient par exemple de 10 à 500 kbits/s.

Cette réduction du suréchantillonnage est réalisée par une opération, appelée décimation, qui consiste à sélectionner un échantillon tous les n échantillons. Le facteur n est appelé facteur de décimation.

De façon classique, l'opération de décimation est précédée d'une opération de filtrage. En effet, l'opération de décimation produit des repliements de spectre. Un filtrage efficace épure la bande fréquentielle aux endroits où les composantes spectrales porteuses d'information doivent venir se replier.

Par ailleurs, on souhaite transposer en bande de base le canal d'intérêt, de façon à rendre possible les traitements qui suivent (filtrage-réception, interpolation, synchronisation, décodage, etc.). Le canal d'intérêt est en effet situé à une fréquence quelconque au sein du multiplex, ce multiplex n'étant lui-même pas nécessairement centré sur la fréquence nulle.

Un démodulateur numérique peut résoudre le problème de canalisation fréquentielle par un filtre décimateur possédant une structure en arbre. Chaque étage de cette structure comprend deux branches, chaque branche réalisant un filtrage sur une sous-bande égale à la moitié de la bande totale qu'elle reçoit, puis une décimation par deux. Cette structure en arbre permet d'extraire simultanément autant de canaux distincts qu'elle possède de sorties, soit 2^{E} canaux distincts si E est le nombre d'étages. Par ailleurs, il est important de noter que cette structure en arbre ne nécessite aucun moyen spécifique de transposition, le filtrage et la décimation effectués à chaque étage ramenant progressivement les porteuses des différents canaux vers la fréquence nulle.

Cependant, cette structure en arbre présente l'inconvénient majeur de ne pas pouvoir être utilisée avec un multiplex quelconque. En effet, cette structure en arbre impose que les porteuses des canaux soient réparties d'une façon très particulière au sein du multiplex. Plus précisément, chaque porteuse de canal doit occuper une position initiale au sein du multiplex telle qu'à chaque étage elle se trouve parfaitement comprise dans l'une des deux sous-bandes de filtrage. On comprend en effet que si à l'entrée d'un étage donné (c'est-à-dire à la sortie du décimateur de l'étage précédent) une porteuse se trouve à la limite entre les sous-bandes associées aux deux filtres de cet étage (chevauchement des zones de transition), alors elle risque d'être conservée ni par l'un ni par l'autre de ces deux filtres.

Par ailleurs, cette structure en arbre est conçue pour extraire tous les canaux du multiplex et est donc surdimensionnée pour l'extraction d'un seul canal parmi une pluralité.

On connaît également, dans l'état de la technique, des solutions concernant uniquement la double opération de filtrage/décimation. Ces solutions connues préconisent d'éviter un filtrage en une étape unique pour des décimations élevées. En effet, cette dernière hypothèse impose de filtrer une large proportion de la bande fréquentielle pour laisser place aux nombreux repliements issus d'une décimation à taux élevé. Or, une telle contrainte signifie que la zone de transition du filtre chargé de cette opération de réjection est étroite, ce qui n'est réalisable qu'au moyen d'un filtre numérique défini par un grand nombre de coefficients, chacun de ces coefficients étant de plus quantifié avec précision - c'est-à-dire au prix d'un grand nombre d'opérations élémentaires sur les bits.

Les solutions connues de filtrage/décimation encouragent plutôt la subdivision de la fonction de filtrage en deux ou trois étages. On gagne alors en complexité sur l'ensemble, le nombre d'opérations pour chaque étage étant significativement réduit. Cependant, dans ces solutions connues, la configuration des différents étages successifs est spécifique à la porteuse et au débit de chaque canal à extraire. En d'autres termes, à chaque étage, le filtrage est adapté aux caractéristiques (porteuse et débit) d'un canal particulier. Par conséquent, deux étages successifs ne sont généralement pas identiques. De plus, un même dispositif de filtrage/décimation ne peut pas être utilisé de façon simple pour deux canaux d'intérêt distincts. Il convient en effet dans ce cas de réactualiser tous les paramètres de filtrage et de décimation de chacun des étages.

En d'autres termes, ces solutions connues de filtrage/décimation présentent l'inconvénient majeur d'imposer une grande capacité de stockage de plusieurs jeux de coefficients de filtrage et de décimation, ainsi qu'un mécanisme de choix des jeux de coefficients pertinents. De plus, les étages étant complètement différents les uns des autres, on ne peut espérer les implémenter en partageant la même ressource de calcul.

Par ailleurs, pour le problème de la transposition, la solution fréquemment retenue consiste à transposer en une seule fois tout le multiplex, de manière à centrer le canal d'intérêt sur la fréquence nulle. Ainsi, les solutions connues précitées de filtrage/décimation, dont le filtrage est centré lui aussi sur la fréquence nulle, peuvent extraire le canal d'intérêt et le décimer.

Une telle transposition est peu avantageuse. En effet, elle est amenée à travailler juste derrière le convertisseur analogique/numérique, à la fréquence d'échantillonnage élevée imposée par celui-ci. Or on aurait plutôt intérêt à réduire au maximum la fréquence d'échantillonnage avant de procéder à la transposition en bande de base. On rappelle en effet que les valeurs accessibles par une transposition fréquentielle sont par nature quantifiées, et que la finesse de cette transposition décroît avec l'augmentation de la fréquence d'échantillonnage, pour une précision donnée. Cette précision se traduit par la taille de la mémoire où sont stockées les valeurs de transposition accessibles. De plus, la bande étant à ce point encore complète, la largeur de la plage fréquentielle que doit pouvoir adresser la transposition est maximale.

L'invention a notamment pour objectif de pallier ces différents inconvénients de l'état de la technique.

Plus précisément, l'un des objectifs de la présente invention est de fournir un dispositif et un procédé numériques de filtrage, décimation et transposition en bande de base, qui présentent des coûts d'implémentation matérielle réduits par rapports à ceux des solutions connues précitées.

L'invention a également pour objectif de fournir un tel dispositif et un tel procédé qui n'imposent aucune contrainte quant au multiplex fréquentiel (et notamment ne nécessitent aucune répartition particulière des porteuses des canaux au sein du multiplex).

Un autre objectif de l'invention est de fournir un tel dispositif et un tel procédé autorisant que certains étages soient structurellement et matériellement identiques.

Un objectif complémentaire de l'invention est de fournir un tel dispositif et un tel procédé qui soient tels que le nombre et la configuration des différents étages ne sont spécifiques ni à la porteuse ni au débit de chaque canal à extraire, mais dépendent uniquement des facteurs de suréchantillonnage initial et final.

Ces différents objectifs, ainsi que d'autres qui apparaîtront par la suite, sont atteints selon l'invention à l'aide d'un dispositif de filtrage, décimation et transposition en bande de base, du type entièrement numérique, permettant d'une part d'extraire et de transposer en bande de base l'un des canaux, dit canal d'intérêt, d'un multiplex fréquentiel de canaux, et d'autre part de réduire le facteur de suréchantillonnage dudit canal d'intérêt, chaque canal étant associé à une porteuse distincte,
ledit dispositif comprenant au moins deux étages en cascade, chaque étage comprenant des moyens de filtrage et des moyens de décimation, lesdits moyens de filtrage étant placés en amont desdits moyens de décimation et permettant d'épurer une partie du spectre aux endroits où les moyens de décimation produisent des repliements de spectre,
caractérisé en ce que chaque étage comprend en outre des moyens de transposition, placés en amont desdits moyens de filtrage et associés à une fréquence de transposition, choisie préalablement parmi un jeu de N fréquences de transposition distinctes possibles, de façon à transposer au plus près de la fréquence nulle la porteuse associée audit canal d'intérêt.

Le principe général de l'invention consiste donc à répartir la transposition en fréquence entre les différents étages de la structure. Ainsi, le canal d'intérêt est transposé en bande de base par pas successifs, chaque pas de transposition pouvant être large. Les moyens de transposition de chaque étage peuvent donc être moins complexes que lorsque la transposition est effectuée en une seule fois.

Si nécessaire, le dernier étage peut être suivi de moyens de transposition fine, de façon à parfaire la transposition en bande de base.

L'invention n'impose aucune contrainte quant au multiplex fréquentiel. En d'autres termes, la porteuse et le débit du canal d'intérêt peuvent être quelconques. En effet, la transposition effectuée en entrée de chaque étage assure un filtrage correct (sans perte d'information) du canal d'intérêt.

L'invention permet en outre l'utilisation de moyens de transposition peu complexes, grâce à la synergie qui existe entre la transposition effectuée à un étage donné et la décimation effectuée à l'étage précédent. En effet, du fait de la décimation effectuée à l'étage précédent, la fréquence d'échantillonnage d'un étage donné est inférieure à celle de l'étage précédent. Par conséquent, pour une même granularité de transposition (c'est-à-dire pour un même écart entre deux fréquences de transposition, exprimé en fonction de la fréquence d'échantillonnage), la transposition effectuée à un étage donné est plus fine que celle effectuée à l'étage précédent. En d'autres termes, la décimation produit un effet loupe qui évite d'avoir à rendre la transposition de plus en plus précise d'étage en étage.

De façon avantageuse, lesdits moyens de décimation sont identiques pour tous les étages. De cette façon, on peut changer de canal d'intérêt sans modifier les moyens de décimation.

Avantageusement, les moyens de décimation de chaque étage présentent un facteur de décimation égal à deux. Ainsi, le filtrage effectué à chaque étage n'a pas à être très puissant.

Préférentiellement, lesdits moyens de filtrage réalisent un filtrage passe-bas demi-bande. Ainsi, l'invention peut être mise en oeuvre avec des filtres demi-bande, qui sont les plus simples à réaliser.

Avantageusement, les moyens de filtrage d'un étage donné réalisent un filtrage passe-bas demi-bande dont la bande de transition est au moins aussi étroite que celle du filtrage passe-bas demi-bande réalisé par les moyens de filtrage de l'étage précédant ledit étage donné.

De cette façon, les filtres peuvent être d'autant plus simples qu'ils sont proches du début de la chaîne, ce qui est un point intéressant puisque les premiers étages travaillent plus vite que les derniers. En d'autres termes, ceci permet, pour les filtres compris dans les premiers étages, de relacher les spécifications d'oscillation dans la bande, et donc de réduire leur nombre de coefficients.

Dans un mode de réalisation préférentiel de l'invention, lesdits moyens de transposition de chaque étage effectuent une multiplication complexe par un coefficient de transposition : C = _{e-j.2π.fₜ.kTₑ}
- fₜ étant ladite fréquence de transposition dudit étage, choisie préalablement parmi un jeu de N fréquences de transposition distinctes possibles, de façon à transposer au plus près de la fréquence nulle la porteuse associée audit canal d'intérêt,
- kTₑ étant le k^{ème} instant d'échantillonnage, k étant un entier défilant avec le temps, et Tₑ = 1/fₑ, avec fₑ la fréquence d'échantillonnage dudit étage.

On rappelle que la transposition effectuée à un étage est d'autant plus fine que le nombre N de fréquences de transposition distinctes possibles est grand (et donc que la granularité de transposition est faible).

Avantageusement, ladite fréquence de transposition fₜ dudit étage s'écrit : fₜ = (l.fₑ)/N, l étant un entier compris entre 0 et N-1.

Selon une variante avantageuse, ladite fréquence de transposition fₜ dudit étage s'écrit : fₜ = (fₑ/(2N)).(2l+1), 1 étant un entier compris entre 0 et N-1.

Il convient de noter que dans les deux cas précités, la granularité de la transposition effectuée à chaque étage est égale à fₑ/n et le coefficient de transposition C peut prendre N valeurs distinctes (modulo N) pour N instants d'échantillonnage successifs.

De façon préférentielle, au moins deux étages successifs, dont le premier étage, sont identiques, seule ladite fréquence de transposition étant spécifique à chaque étage, et lesdits au moins deux étages successifs identiques sont réalisés avec une unique cellule matérielle dont les moyens de transposition, filtrage et décimation sont partagés par lesdits au moins deux étages successifs identiques.

Par étages identiques, on entend des étages comprenant des moyens de transposition, des moyens de filtrage et des moyens de décimation identiques. Concernant les moyens de transposition, cela signifie que les jeux de N fréquences de transposition possibles des différents étages sont identiques. Bien sûr, cela ne signifie pas que la fréquence de transposition choisie soit la même pour tous les étages identiques.

Ainsi, en partageant les ressources matérielles ("hardware") destinées à exécuter les étages identiques, on réalise un gain important en puissance de calcul (et donc en surface d'ASIC). En effet, on réalise tous les étages identiques avec une seule cellule matérielle travaillant à une vitesse suffisante pour mener un traitement parallèle. Ce traitement parallèle est possible du fait que chaque étage travaille moins vite que l'étage qui le précède (grâce à la décimation).

De façon préférentielle, la finesse de la transposition réalisée par les moyens de transposition d'un étage donné est supérieure ou égale à la finesse de la transposition réalisée par les moyens de transposition de l'étage précédant ledit étage donné.

Ainsi, les transpositions peuvent être d'autant plus simples qu'elles sont proches du début de la chaîne, ce qui est un point intéressant puisque les premiers étages travaillent plus vite que les derniers. En d'autres termes, les transpositions nécessitant le plus de calcul (c'est-à-dire les plus fines) sont effectuées à des vitesses de travail (ou fréquences d'échantillonnage) moins élevées.

De façon avantageuse, en fonction des facteurs de suréchantillonnage initial et final dudit canal d'intérêt, respectivement en entrée et en sortie dudit dispositif, ledit multiplex fréquentiel de canaux est appliqué directement à un étage approprié situé en aval du premier étage.

En d'autres termes, selon le suréchantillonnage initial, on peut décider de ne pas faire passer le signal par un ou plusieurs des premiers étages, et le faire entrer directement dans un étage intermédiaire.

L'invention concerne également un procédé de filtrage, décimation et transposition en bande de base, du type entièrement numérique, permettant d'une part d'extraire et de transposer en bande de base un canal particulier, dit canal d'intérêt, d'un multiplex fréquentiel de canaux, et d'autre part de réduire le facteur de suréchantillonnage dudit canal d'intérêt, chaque canal étant associé à une porteuse distincte,
caractérisé en ce que les opérations de filtrage, décimation et transposition en bande de base sont effectuées en au moins deux phases de traitement successives, chaque phase de traitement comprenant les étapes successives suivantes :
- transposition, permettant de transposer au plus près de la fréquence nulle la porteuse associée audit canal d'intérêt ;
- filtrage ;
- décimation, ladite étape de filtrage permettant d'épurer une partie du spectre aux endroits où l'étape de décimation produit des repliements de spectre.

Avantageusement, ledit procédé comprend une phase préalable de détermination du nombre de phases de traitement successives ainsi que des caractéristiques de transposition, filtrage et décimation de chacune desdites phases de traitement, le facteur de décimation de chaque étage étant supposé connu, le facteur de suréchantillonnage initial en entrée du premier étage étant supposé connu, un facteur maximal de suréchantillonnage en sortie du dernier étage étant imposé,
ladite phase préalable comprend les étapes suivantes :
- on considère la dernière phase de traitement : on détermine des caractéristiques optimales de transposition (en termes de finesse de transposition) et de filtrage (en termes d'écart par rapport au filtrage idéal) permettant d'obtenir ledit facteur maximal de suréchantillonnage imposé en sortie de la dernière phase de traitement;
- on considère la phase de traitement précédente :
   * à partir du facteur de décimation de la phase de traitement suivante et du facteur maximal de suréchantillonnage imposé en sortie de la phase de traitement suivante, on calcule le facteur maximal de suréchantillonnage requis en sortie de ladite phase de traitement précédente ;
   * on détermine les caractéristiques optimales de transposition et de filtrage permettant d'obtenir ledit facteur maximal de suréchantillonnage requis préalablement calculé ;
- on reconduit le même raisonnement jusqu'à ce qu'une phase de traitement précédente, dite première phase de traitement, soit telle que si ledit facteur de suréchantillonnage initial lui est appliqué alors le facteur de suréchantillonnage en sortie de ladite première phase de traitement est inférieur au facteur maximal de suréchantillonnage requis préalablement calculé.

Cette phase préalable permet d'optimiser individuellement les filtres des différents étages, en partant du dernier pour remonter vers le premier.

Préférentiellement, ladite phase préalable comprend également une ultime étape consistant à :
- pour la ou les X dernière(s) phase(s) de traitement, avec X ≥ 1 : conserver les caractéristiques optimales de transposition et de filtrage, propres à chaque phase de traitement ;
- pour chacune des L-X premières phases de traitement, avec L le nombre total de phases de traitement et L-X ≥ 2 : remplacer les caractéristiques optimales de transposition et de filtrage, propres à chaque phase de traitement, par des caractéristiques de transposition et de filtrage communes, et égales à celles de la L-X^{ème} phase de traitement.

Il apparaît en effet qu'à partir d'un certain étage (le L-Xème avec les présentes notations), et jusqu'au premier étage, les filtrages sont extrêmement simples à réaliser, et que l'on ne gagne plus beaucoup sur leur complexité en les optimisant individuellement. On décide donc dans ce cas de les prendre identiques, de façon notamment à pouvoir les mettre en oeuvre avec une unique cellule matérielle.

L'invention concerne aussi un démodulateur numérique, du type comprenant au moins une chaîne de démodulation monocanal, chaque chaîne comprenant un dispositif de filtrage, décimation et transposition en bande de base tel que précité.

D'autres caractéristiques et avantages de l'invention apparaîtront à la lecture de la description suivante de deux modes de réalisation préférentiels de l'invention, donnés à titre d'exemple indicatif et non limitatif, et des dessins annexés, dans lesquels :
- la figure 1 présente un exemple de multiplex fréquentiel reçu par un dispositif selon l'invention de filtrage, décimation et transposition en bande de base ;
- la figure 2 présente un schéma simplifié d'un mode de réalisation particulier d'un démodulateur selon l'invention ;
- la figure 3 présente un schéma simplifié d'un mode de réalisation particulier d'une chaîne de démodulation monocanal apparaissant sur la figure 2 ;
- la figure 4 présente un premier mode de réalisation d'un dispositif selon l'invention de filtrage, décimation et transposition en bande de base, apparaissant sur la figure 3 ;
- les figures 5A à 5E permettent d'expliciter à travers un exemple le fonctionnement du dispositif de la figure 4, chaque figure présentant un même canal d'intérêt à différents points du dispositif, à savoir :
   * en entrée du premier étage (fig.5A),
   * après les moyens de transposition du premier étage (fig.5B),
   * après les moyens de filtrage et de décimation du premier étage (fig.5C),
   * après les moyens de transposition du second étage (fig.5D),
   * après les moyens de filtrage et de décimation du second étage (fig.5E) ;

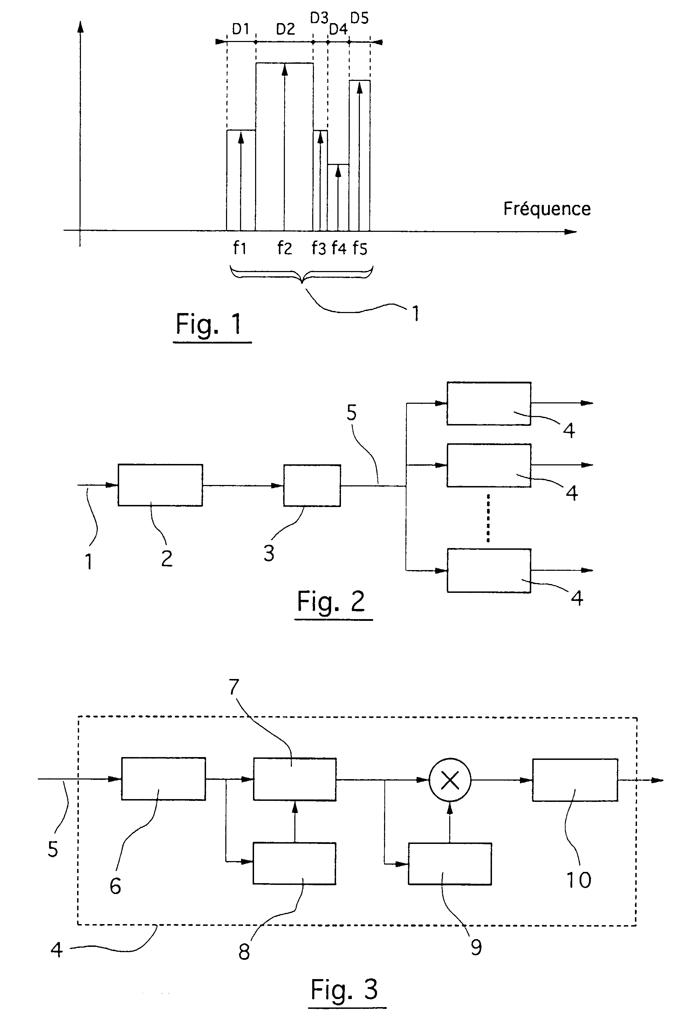

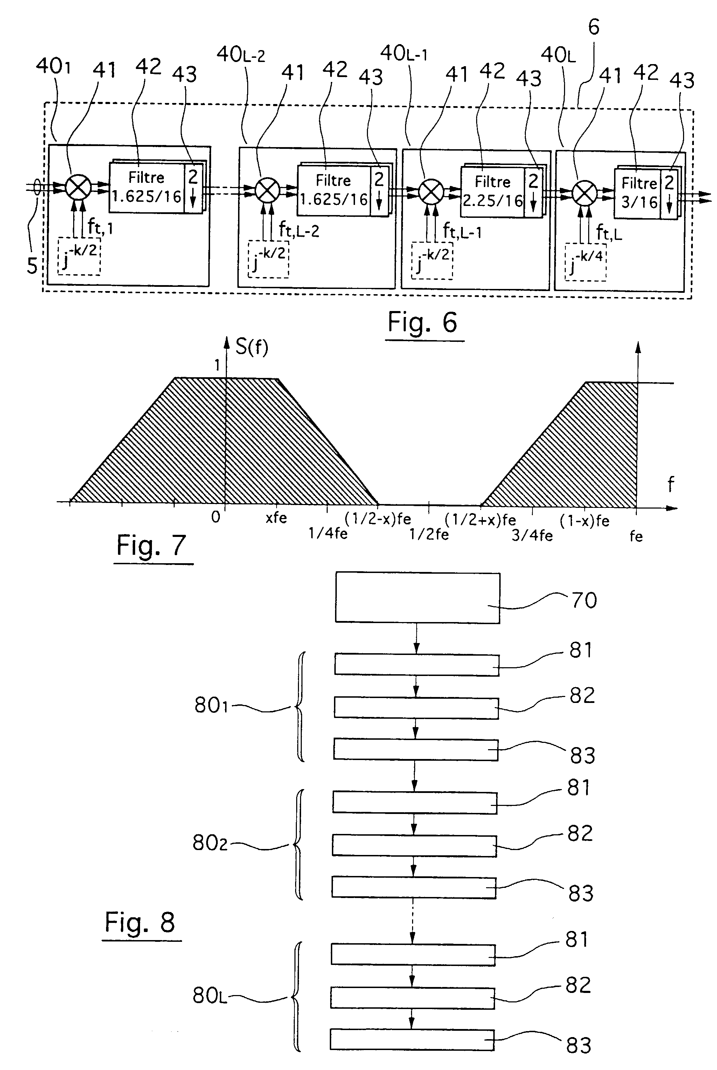

- la figure 6 présente un second mode de réalisation d'un dispositif selon l'invention de filtrage, décimation et transposition en bande de base, apparaissant sur la figure 3 ;

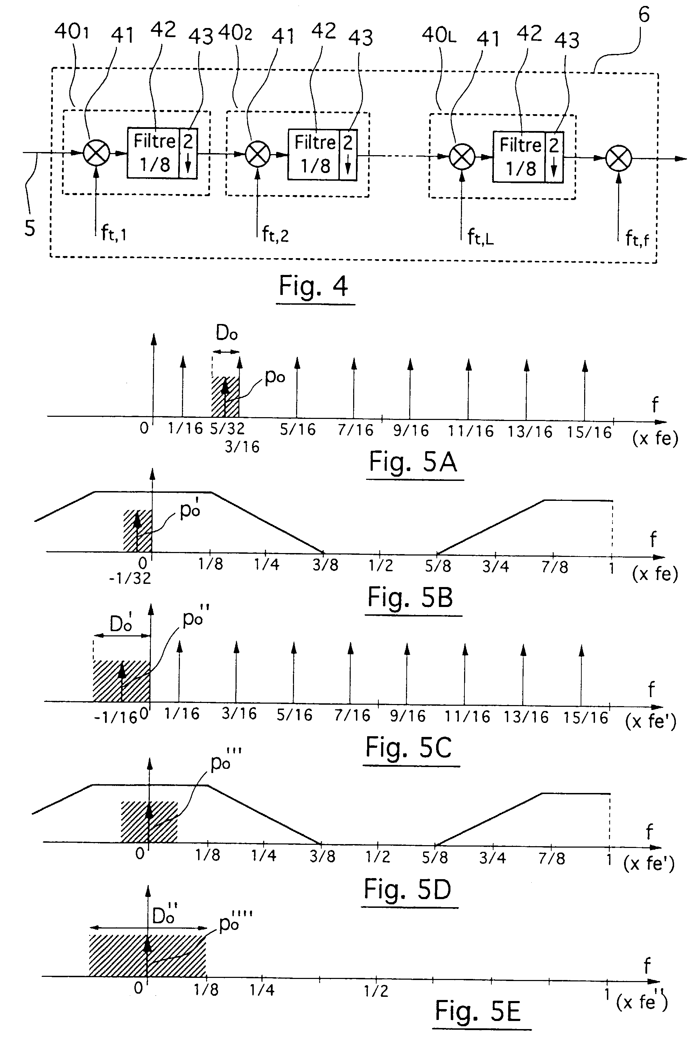

- la figure 7 présente la réponse fréquentielle d'une famille de filtres, dits filtres demi-bande, pouvant être utilisés dans le dispositif de la figure 4 ou 6 ; et
- la figure 8 présente un organigramme simplifié d'un mode de réalisation particulier du procédé selon l'invention de filtrage, décimation et transposition en bande de base.

D'une façon générale, et comme présenté sur l'exemple de la figure 1, un multiplex 1 comprend une pluralité de canaux associés chacun à une porteuse f₁ à f₅ et un débit D1 à D5.

L'invention concerne un dispositif et un procédé de filtrage, décimation et transposition en bande de base de l'un des canaux (dit canal d'intérêt) d'un tel multiplex fréquentiel 1.

L'invention concerne également un démodulateur numérique comprenant un tel dispositif. Comme présenté sur le schéma de la figure 2, dans un mode de réalisation particulier, le démodulateur selon l'invention comprend une chaîne de réception 2, des moyens 3 de conversion analogique/numérique et une pluralité de chaînes de démodulation monocanal 4 (également appelées chaînes de démodulation monoporteuse).

La chaîne de réception 2 est large bande, du fait qu'elle doit permettre de recevoir l'ensemble du multiplex 1, et travaille en fréquence intermédiaire, si l'on suppose que le multiplex 1 a préalablement été transposé en fréquence intermédiaire.

Les moyens 3 de conversion analogique/numérique permettent de numériser l'ensemble du multiplex reçu 1. La fréquence de conversion analogique/numérique (ou fréquence d'échantillonnage) est choisie en rapport avec la bande du multiplex fréquentiel 1. De ce fait, le débit d'échantillons du multiplex numérisé 5 est très supérieur au débit de symboles du canal d'intérêt. En d'autres termes, la largeur du canal d'intérêt est faible devant la fréquence d'échantillonnage.

Enfin, chaque chaîne de démodulation monocanal 4 permet de traiter un des canaux du multiplex numérisé 5.

Dans l'exemple présenté sur la figure 2, le démodulateur comprend une pluralité de chaînes de démodulation monocanal 4. Il est clair cependant que le démodulateur de l'invention peut ne comprendre qu'une chaîne de démodulation monocanal 4.

Comme présenté sur la figure 3, dans un mode de réalisation particulier, chaque chaîne de démodulation monocanal 4 comprend un dispositif 6 de filtrage, décimation et transposition en bande de base, des moyens 7 de filtrage réception, des moyens 8 d'estimation de rythme, des moyens 9 d'estimation de porteuse et des moyens 10 assurant diverses autres fonctions (décodage notamment).

A l'exception du dispositif 6 de filtrage, décimation et transposition, les divers moyens 7 à 10 précités travaillent en bande de base. Ils sont donc tout à fait classiques, et l'homme du métier saura aisément les mettre en oeuvre.

En revanche, le dispositif 6 de filtrage, décimation et transposition doit opérer à une fréquence beaucoup plus élevée, et constitue donc un point critique. La présente invention propose une architecture simple et performante pour réaliser ce dispositif 6.

On présente maintenant un premier et un second modes de réalisation du dispositif 6 selon l'invention de filtrage, décimation et transposition en bande de base. Le premier mode de réalisation est présenté en relation avec les figures 4 et 5A à 5E. Le second mode de réalisation est présenté en relation avec les figures 6 et 7.

Dans les deux modes de réalisation présentés (cf figures 4 et 6), le dispositif 6 comprend une pluralité d'étages 40₁ à 40_{L} en cascade. Chaque étage 40₁ à 40_{L} comprend des moyens 41 de transposition, des moyens 42 de filtrage et des moyens 43 de décimation.

Les moyens 41 de transposition, placés en entrée de l'étage, sont associés à une fréquence de transposition f_{t,1} à f_{t,L}, choisie préalablement parmi un jeu de N fréquences de transposition distinctes possibles. Ils permettent de transposer au plus près de la fréquence nulle la porteuse associée au canal d'intérêt.

Les moyens 41 de transposition de chaque étage 40₁ à 40_{L} effectuent une multiplication complexe par un coefficient de transposition : Cᵢ = e_{-j.2πf_{t,i}kTₑ}
- f_{t,i} étant la fréquence de transposition du ième étage,
- kTₑ étant le k^{ème} instant d'échantillonnage, k étant un entier défilant avec le temps, et Tₑ = 1/fₑ, avec fₑ la fréquence d'échantillonnage du ième étage.

Une fois choisie, la fréquence de transposition f_{t,i} est fixe. En revanche, le coefficient de transposition Cᵢ varie avec le temps (c'est-à-dire lorsque k varie).

Il est important de noter que du fait de la décimation (41) effectuée à chaque étage, chaque étage 40₁ à 40_{L} possède sa propre fréquence d'échantillonnage (qui est d'autant plus faible que l'étage est proche de la sortie du dispositif 6).

La fréquence de transposition f_{t,i} du ième étage peut être définie de plusieurs façons. On donne ci-dessous deux définitions possibles. Il est clair que d'autres définitions peuvent être envisagées par l'homme du métier, sans sortir du cadre de la présente invention.

Selon une première définition, elle s'écrit : f_{t,i} = (l.fₑ)/N, l étant un entier compris entre 0 et N-1. En prenant les N valeurs distinctes de 1, on obtient le jeu de N fréquences de transposition distinctes possibles. Ainsi, par exemple, si N = 8, on obtient le jeu suivant de fréquences de transposition : fₜ ∈ {0, fₑ/8, 2fₑ/8, 3fₑ/8, 4fₑ/8, 5fₑ/8, 6fₑ/8, 7fₑ/8}.

Selon une seconde définition, la fréquence de transposition f_{t,i} du ième étage s'écrit : fₜ = (fₑ/(2N)).(2l+1), 1 étant un entier compris entre 0 et N-1. Comme précédemment, en prenant les N valeurs distinctes de 1, on obtient le jeu de N fréquences de transposition distinctes possibles. Ainsi, par exemple, si N = 8, on obtient le jeu suivant de fréquences de transposition : fₜ ∈ {fₑ/16, 3fₑ/16, 5fₑ/16, 7fₑ/16, 9fₑ/16, 11fₑ/16, 13fₑ/16, 15fₑ/16}.

D'une façon générale, la finesse (ou précision) d'une transposition s'apprécie par sa granularité G, qui est l'écart minimal entre deux fréquences de transposition possibles. Ainsi, avec les deux définitions précitées, on a : G = fₑ/N. On note que la transposition est d'autant plus précise (c'est-à-dire que la granularité est d'autant plus faible) que N est grand.

Par ailleurs, avec les deux définitions précitées de la fréquence de transposition, le coefficient de transposition Cᵢ varie selon k, modulo N. En effet, il ne peut prendre que N valeurs distinctes. Avec la première définition de la fréquence de transposition, il est fréquent de noter j-^{41/N} ce jeu de N valeurs distinctes du coefficient de transposition. Ainsi, par exemple, pour N = 4, on a j⁻¹ ; pour N = 8, on a j-^{1/2} ; pour N = 16, on a j-^{1/4}.

Les moyens 42 de filtrage sont placés en amont des moyens 43 de décimation. Ils permettent d'épurer une partie du spectre aux endroits où les moyens 43 de décimation produisent des repliements de spectre.

La figure 7 présente la réponse fréquentielle d'une famille de filtres, dits filtres demi-bande, pouvant être utilisés dans le premier et le second modes de réalisation du dispositif 6. Cette réponse fréquentielle s'écrit, en la supposant normalisée :

| | | |
|---|---|---|
| S(f) | = 1 | pour f ∈ [0, x.fₑ] |
| | = (1/(4x - 1)).(2f/fe + 2x - 1) | pour f ∈ [x.fₑ, (1/2 - x).fₑ] |
| | = 0 | pour f ∈ [(1/2 - x).fₑ, (1/2 + x).fₑ] |
| | = (1/(4x - 1)).(- 2f/fe + 2x +1) | pour f ∈ [(1/2 + x).fₑ, (1 - x).fₑ] |
| | = 1 | pour f ∈ [(1 - x).fₑ, fₑ] |

Chaque filtre de cette famille correspond à une valeur particulière de la fréquence maximale x de la bande passante, avec x ∈ [0, 1/4]. La valeur x = 1/4 correspond à un filtre demi-bande idéal, puisque l'intervalle de transition [x.fₑ, (1/2 - x).fₑ] y est réduit à zéro (pente de transition infinie). Dans la réalité, plus la pente de transition du filtre est élevée, plus le filtre est difficile à réaliser.

Dans les deux modes de réalisation présentés, les moyens 43 de décimation sont identiques pour tous les étages 40₁ à 40_{L}, et effectuent une décimation par deux. On rappelle qu'un tel facteur de décimation présente l'avantage de ne pas nécessiter un filtrage préalable très puissant.

Optionnellement (cf figure 4), le dernier étage 40_{L} peut être suivi de moyens 44 de transposition fine, de façon à parfaire la transposition en bande de base.

Dans le premier mode de réalisation du dispositif (cf figure 4), les moyens 42 de filtrage sont identiques pour tous les étages 40₁ à 40_{L}, et réalisent un filtrage demi-bande avec x = 1/8. Les moyens 41 de transposition sont également pris identiques pour tous les étages 40₁ à 40_{L}. En d'autres termes, tous les étages disposent d'un même jeu de N fréquences de transposition distinctes possibles, seul le choix d'une fréquence de transposition parmi les N possibles du jeu est spécifique à chaque étage.

Ainsi, dans ce premier mode de réalisation, tous les étages 40₁ à 40_{L} sont identiques (mêmes moyens 41 de transposition, mêmes moyens 42 de filtrage et mêmes moyens 43 de décimation). On peut donc les réaliser avec une unique cellule matérielle (ou cellule hardware) qui doit travailler à une vitesse suffisante pour mener en parallèle le traitement des différents étages. L'implémentation matérielle est donc très simple.

On note que si le premier étage 40₁ impose une cadence de traitement de fₑ (fréquence d'échantillonnage), le second étage 40₂ se suffit d'une cadence moitié fₑ/2 (du fait de la décimation par deux effectuée dans le premier étage), le troisième étage 40₃ se suffit d'une cadence fₑ/4 (du fait de la décimation par deux effectuée dans le second étage), etc. Le premier étage est le plus exigeant. Si l'on néglige les opérations d'initialisation et de transfert, le premier étage requiert une puissance de traitement supérieure (et égale quand le nombre d'étages tend vers l'infini) à celles réunies de tous les étages qui le suivent. Dans une cascade de 3 étages, le cadencement le plus efficace est 4 fois le premier étage, 2 fois le second étage, 1 fois le troisième étage, puis on recommence au début. On notera que ce cadencement est cohérent avec les fréquences d'échantillonnage imposées aux étages successifs.

On présente maintenant, en relation avec les figures 5A à 5E, un exemple le fonctionnement du dispositif 6 de la figure 4. Chacune de ces figures présente un même canal d'intérêt (représenté en hachuré) à différents points du dispositif.

On suppose qu'en entrée du premier étage (cf fig.5A), le canal d'intérêt (que l'on cherche à extraire du multiplex et à transposer en bande de base) est associé à une porteuse p₀ = (5/32).fₑ (avec fₑ la fréquence d'échantillonnage dans le premier étage 40₁) et à un débit D₀ = (1/16).fₑ. On suppose également que N = 8, avec le jeu suivant de fréquences de transposition : fₜ ∈ {fₑ/16, 3fₑ/16, 5fₑ/16, 7fₑ/16, 9fₑ/16, 11fₑ/16, 13fₑ/16, 15fₑ/16}.

La fréquence de transposition 3fₑ/16 est la plus proche de la porteuse p₀. Par conséquent, c'est celle qui est choisie pour le premier étage. En réalité, on transpose de (- fₜ), avec fₜ la fréquence de transposition.

Après les moyens 41 de transposition du premier étage (cf fig.5B), la porteuse est devenue : p₀' = (5/32 - 3/16).fₑ = (- 1/32).fₑ. Comme cela apparaît sur la figure 5B, le filtrage demi-bande 42 (dont la réponse en fréquence est représentée) peut être effectué sans engendrer de pertes pour le canal d'information.

La figure 5C présente le canal d'intérêt en entrée du second étage, c'est-à-dire après les moyens de filtrage 42 et de décimation 43 du premier étage. Les fréquences sont maintenant notées en fonction de fₑ', avec fₑ' la fréquence d'échantillonnage après décimation par deux (fₑ' = fₑ/2). On a donc : p₀'' = (- 1/16).fₑ' et D₀' = (1/8).fₑ'.

La fréquence de transposition - fₑ/16 est la plus proche de la porteuse p₀. Par conséquent, on choisit la fréquence de transposition 15fₑ/16 pour le second étage. En effet, transposer de 15fₑ/16 équivaut à transposer de - fₑ/16.

Après les moyens 41 de transposition du second étage (cf fig.5D), la porteuse est devenue : p₀''' = (- 1/32 + 1/32).fₑ = 0. Le canal d'intérêt a donc été ramené en bande de base et le filtrage demi-bande 42 (dont la réponse en fréquence est représentée) peut être effectué sans engendrer de pertes pour le canal d'information.

La figure 5E présente le canal d'intérêt après les moyens de filtrage 42 et de décimation (par deux) 43 du second étage. Les fréquences sont maintenant notées en fonction de fₑ'', avec fₑ'' la fréquence d'échantillonnage après décimation par deux (fₑ'' = fₑ'/2 = fₑ/4). On a donc : p₀'''' = 0 et D₀'' = fₑ''/4.

On rappelle que le suréchantillonnage S en un point est défini comme le rapport entre la fréquence d'échantillonnage fₑ et le débit D en ce point : S = fₑ/D. Dans l'exemple présenté ci-dessus, le suréchantillonnage en entrée du dispositif 6 est Sₑ = fₑ/D₀ = 16. Le suréchantillonnage en sortie du dispositif 6 est Sₛ = fₑ''/D₀'' = fₑ''/(fₑ''/4) = 4.

Dans l'exemple présenté ci-dessus en relation avec les figures 5A à 5E, et qui est donné uniquement à titre explicatif, le dispositif 6 comprend deux étages et permet de ramener le canal d'intérêt en bande de base et de réduire le facteur de suréchantillonnage à S = 4.

Dans le second mode de réalisation du dispositif (cf figure 6), les moyens de transposition 41 et les moyens 42 de filtrage ne sont pas identiques pour tous les étages 40₁ à 40_{L}. Les caractéristiques de transposition et de filtrage de chaque étage sont dans ce cas choisies de façon à être optimales. Comme on le verra par la suite, on gagne à choisir identiques les étages qui différent peu. En effet, si l'on perd alors un peu sur l'optimalité du filtrage et de la transposition, on gagne en contrepartie beaucoup en puissance de calcul (donc en surface pour un ASIC) puisque l'on peut utiliser une seule cellule matérielle pour réaliser tous les étages identiques.

On présente maintenant, en relation avec la figure 6, le procédé d'optimisation du nombre d'étages et des caractéristiques de transposition et de filtrage de chacun de ces étages.

On suppose que l'unique paramètre d'optimisation est le suréchantillonnage S requis en sortie du dispositif 6. On demande par exemple que S ne dépasse pas 4,48, c'est-à-dire que le dernier étage 40_{L} garantisse à sa sortie que S ∈ [2,24 ; 4,48].

On suppose également que les filtres utilisés sont du type demi-bande (cf explication ci-dessus, en relation avec la figure 7). La fréquence maximale de la bande passante est désignée par x, en supposant la fréquence d'échantillonnage fₑ normalisée à 1.

On considère tout d'abord le dernier étage 40_{L}. On aborde deux cas :
- soit la transposition du dernier étage a une finesse de fₑ/8 (c'est-à-dire N = 8), alors dans le pire cas : 1/[2.(x - 1/16)] = Smax / (1 + α), où α est le roll-off du filtre adapté. Ce qui donne : x = 1/16 + (1 + α) / (2.Smax).
   Application numérique : avec α = 0,4 et Smax = 4,48, on trouve : x = 3,5 / 16. On constate que cette valeur est très proche de la valeur limite x₁ = 1/4 = 4/16. La difficulté porte sur la réalisation d'un filtre présentant une transition aussi brutale. Un second cas est donc envisagé.
- soit la transposition du dernier étage a une finesse de fₑ/16 (c'est-à-dire N = 16), alors dans le pire cas : 1/[2.(x - 1/32)] = Smax / (1 + α), où α est le roll-off du filtre adapté. Ce qui donne : x = 1/32 + (1 + α) / (2.Smax). Application numérique : avec α = 0,4 et Smax = 4,48, on trouve : x = 3 / 16. Cette valeur est plus raisonnable. Elle est adoptée dans la réalité.

On considère ensuite l'avant-dernier étage 40_{L-1}. Conformément à l'architecture générale, il faut (et il suffit) en sortie de cet étage que le suréchantillonnage respecte S ∈ [4,48 ; 8,96]. On suppose que la transposition de l'avant-dernier étage a une finesse de fₑ/8, alors dans le pire cas : 1/[2.(x - 1/16)] = Smax / (1 + α), où α est le roll-off du filtre adapté. Ce qui donne : x = 1/16 + (1 + α)/(2.Smax). Application numérique : avec α = 0,4 et Smax = 8,96, on trouve : x = 2,25 / 16.

On considère ensuite l'étage précédent 40_{L-2}. Il faut que le suréchantillonnage respecte S ∈ [8,96 ; 17,92]. On suppose que la transposition de l'avant-dernier étage a une finesse de fₑ/8, alors dans le pire cas : 1/[2.(x - 1/16)] = Smax / (1 + α), où α est le roll-off du filtre adapté. Ce qui donne : x = 1/16 + (1 + α) / (2.Smax). Application numérique : avec α = 0,4 et Smax = 17,92, on trouve : x = 1,625 / 16.

On peut désormais reconduire le même raisonnement, itérativement, jusqu'au premier étage 40₁, c'est-à-dire jusqu'à un étage capable de recevoir le multiplex fréquentiel 5 ayant un facteur de suréchantillonnage d'entrée prédéterminé. Ainsi, on a décrit un procédé d'optimisation des moyens 41 de transposition et des moyens 42 de filtrage de chaque étage, en partant du dernier étage et de ses contraintes de suréchantillonnage, puis en remontant vers le premier étage. On remarque que les moyens 41, 42 de transposition et de filtrage sont d'autant plus simples qu'ils sont proches du début de la chaîne, ce qui est intéressant puisque les premiers étages travaillent plus vite que les derniers.

Si l'on souhaite avoir une structure plus générale (c'est-à-dire pouvant être utilisée avec différents canaux d'intérêt), on peut prévoir un grand nombre d'étages, et, en fonction du facteur de suréchantillonnage d'entrée, appliquer directement le multiplex à un étage approprié situé en aval du premier étage. En d'autres termes, on n'utilise alors que le nombre minimal d'étages nécessaires (en ne passant par un ou plusieurs étages de tête).

Par ailleurs, dans l'exemple présenté, on constate qu'à partir de l'antépénultième étage 40_{L-2}, les filtres 42 sont extrêmement simples à réaliser, et que leur optimisation individuelle ne présente plus beaucoup d'intérêt. Dans ce cas, il est préférable de prendre les L-2 premiers étages 40₁ à 40_{L-2} identiques. En généralisant, on peut parler des L-X premiers étages. En effet, de cette façon, on peut partager les ressources matérielles (hardware) destinées à exécuter ces différents étages. En résumé, dans cette variante (cf figure 6), on a L-2 premiers étages identiques 40₁ à 40_{L-2}, suivis de deux étages spécifiques 40_{L-1} et 40_{L}.

On présente maintenant, en relation avec l'organigramme de la figure 8, un mode de réalisation particulier du procédé selon l'invention de filtrage, décimation et transposition en bande de base. Les opérations de filtrage, décimation et transposition en bande de base sont effectuées en au moins deux phases de traitement successives 80₁ à 80_{L}. Chaque phase de traitement comprend les étapes successives suivantes :
- transposition 81, permettant de transposer au plus près de la fréquence nulle la porteuse associée au canal d'intérêt ;
- filtrage 82 ;
- décimation 83, l'étape de filtrage 82 permettant d'épurer une partie du spectre aux endroits où l'étape de décimation 83 produit des repliements de spectre.

Chaque phase de traitement 80₁ à 80_{L} est par exemple mise en oeuvre dans un étage 40₁ à 40_{L} du dispositif 6 présenté ci-dessus en relation avec les figures 1 à 7.

Le procédé comprend en outre une phase préalable 70 de détermination du nombre de phases de traitement successives ainsi que des caractéristiques de transposition, filtrage et décimation de chacune des phases de traitement 80₁ à 80_{L}. Selon l'invention, cette phase préalable 70 peut être optimisée. C'est l'optimisation, déjà décrite ci-dessus, du nombre d'étages du dispositif 6 de filtrage, décimation et transposition en bande de base et des caractéristiques de transposition et de filtrage de chacun de ces étages 40₁ à 40_{L}.

## Revendications

1. Dispositif de filtrage, décimation et transposition en bande de base, du type entièrement numérique, permettant d'une part d'extraire et de transposer en bande de base l'un des canaux, dit canal d'intérêt, d'un multiplex fréquentiel de canaux, et d'autre part de réduire le facteur de suréchantillonnage dudit canal d'intérêt, chaque canal étant associé à une porteuse distincte,
ledit dispositif comprenant au moins deux étages en cascade (40₁ à 40_{L}), chaque étage comprenant des moyens (42) de filtrage et des moyens (43) de décimation, lesdits moyens de filtrage étant placés en amont desdits moyens de décimation et permettant d'épurer une partie du spectre aux endroits où les moyens de décimation produisent des repliements de spectre,
caractérisé en ce que chaque étage (40₁ à 40_{L}) comprend en outre des moyens (41) de transposition, placés en amont desdits moyens (42) de filtrage et associés à une fréquence de transposition (f_{t,i}), choisie préalablement parmi un jeu de N fréquences de transposition distinctes possibles, de façon à transposer au plus près de la fréquence nulle la porteuse (p₀) associée audit canal d'intérêt.

2. Dispositif selon la revendication 1, caractérisé en ce que lesdits moyens (41) de décimation sont identiques pour tous les étages (40₁ à 40_{L}).

3. Dispositif selon l'une quelconque des revendications 1 et 2, caractérisé en ce que les moyens (43) de décimation de chaque étage (40₁ à 40_{L}) présentent un facteur de décimation égal à deux.

4. Dispositif selon l'une quelconque des revendications 1 à 3, caractérisé en ce que lesdits moyens (42) de filtrage réalisent un filtrage passe-bas demi-bande.

5. Dispositif selon l'une quelconque des revendications 1 à 4, caractérisé en ce que les moyens (42) de filtrage d'un étage donné réalisent un filtrage passe-bas demi-bande dont la zone de transition est au moins aussi étroite que celle du filtrage passe-bas demi-bande réalisé par les moyens de filtrage de l'étage précédant ledit étage donné.

6. Dispositif selon l'une quelconque des revendications 1 à 5, caractérisé en ce que lesdits moyens (41) de transposition de chaque étage (40₁ à 40_{L}) effectuent une multiplication complexe par un coefficient de transposition : C = e_{-j.2π.f_{t,}kTₑ}
- fₜ étant ladite fréquence de transposition dudit étage, choisie préalablement parmi un jeu de N fréquences de transposition distinctes possibles, de façon à transposer au plus près de la fréquence nulle la porteuse associée audit canal d'intérêt.
- kTₑ étant le k^{ème} instant d'échantillonnage, k étant un entier défilant avec le temps, et Tₑ = 1/fₑ, avec fₑ la fréquence d'échantillonnage dudit étage.

7. Dispositif selon la revendication 6, caractérisé en ce que ladite fréquence de transposition fₜ dudit étage s'écrit : fₜ = (l.fₑ)/N, l étant un entier compris entre 0 et N-1.

8. Dispositif selon la revendication 6, caractérisé en ce que ladite fréquence de transposition fₜ dudit étage s'écrit : fₜ = (fₑ/(2N)).(2l+1), l étant un entier compris entre 0 et N-1.

9. Dispositif selon l'une quelconque des revendications 1 à 8, caractérisé en ce que au moins deux étages successifs (fig.4, 40₁ à 40_{L}), dont le premier étage, sont identiques, seule ladite fréquence de transposition étant spécifique à chaque étage,
et en ce que lesdits au moins deux étages successifs identiques sont réalisés avec une unique cellule matérielle dont les moyens de transposition, filtrage et décimation sont partagés par lesdits au moins deux étages successifs identiques.

10. Dispositif selon l'une quelconque des revendications 1 à 9, caractérisé en ce que la finesse de la transposition réalisée par les moyens (41) de transposition d'un étage donné (fig.6, 40ᵢ) est supérieure ou égale à la finesse de la transposition réalisée par les moyens de transposition (41) de l'étage (fig.6, 40ᵢ₋₁) précédant ledit étage donné.

11. Dispositif selon l'une quelconque des revendications 1 à 10, caractérisé en ce que, en fonction des facteurs de suréchantillonnage initial et final dudit canal d'intérêt, respectivement en entrée et en sortie dudit dispositif, ledit multiplex fréquentiel de canaux est appliqué directement à un étage approprié situé en aval du premier étage.

12. Procédé de filtrage, décimation et transposition en bande de base, du type entièrement numérique, permettant d'une part d'extraire et de transposer en bande de base un canal particulier, dit canal d'intérêt, d'un multiplex fréquentiel de canaux, et d'autre part de réduire le facteur de suréchantillonnage dudit canal d'intérêt, chaque canal étant associé à une porteuse distincte,
caractérisé en ce que les opérations de filtrage, décimation et transposition en bande de base sont effectuées en au moins deux phases de traitement successives (80₁ à 80_{L}), chaque phase de traitement comprenant les étapes successives suivantes :
- transposition (81), permettant de transposer au plus près de la fréquence nulle la porteuse associée audit canal d'intérêt ;
- filtrage (82) ;
- décimation (83), ladite étape de filtrage permettant d'épurer une partie du spectre aux endroits où l'étape de décimation produit des repliements de spectre.

13. Procédé selon la revendication 12, caractérisé en ce qu'il comprend une phase préalable (70) de détermination du nombre de phases de traitement successives ainsi que des caractéristiques de transposition, filtrage et décimation de chacune desdites phases de traitement, le facteur de décimation de chaque étage étant supposé connu, le facteur de suréchantillonnage initial en entrée du premier étage étant supposé connu, un facteur maximal de suréchantillonnage en sortie du dernier étage étant imposé,
ladite phase préalable comprend les étapes suivantes :
- on considère la dernière phase de traitement : on détermine des caractéristiques optimales de transposition (en termes de finesse de transposition) et de filtrage (en termes d'écart par rapport au filtrage idéal) permettant d'obtenir ledit facteur maximal de suréchantillonnage imposé en sortie de la dernière phase de traitement;
- on considère l'avant-denière phase de traitement :
* à partir du facteur de décimation de la dernière phase de traitement et du facteur maximal de suréchantillonnage imposé en sortie de la dernière phase de traitement, on calcule le facteur maximal de suréchantillonnage requis en sortie de ladite avant-dernière phase de traitement ;
* on détermine les caractéristiques optimales de transposition et de filtrage permettant d'obtenir ledit facteur maximal de suréchantillonnage requis en sortie de ladite avant-dernière phase de traitement ;
- on reconduit le même raisonnement jusqu'à ce qu'une phase de traitement précédente, dite première phase de traitement, soit telle que si ledit facteur de suréchantillonnage initial lui est appliqué alors le facteur de suréchantillonnage en sortie de ladite première phase de traitement est inférieur au facteur maximal de suréchantillonnage requis préalablement calculé.

14. Procédé selon la revendication 13, caractérisé en ce que ladite phase préalable (70) comprend également une ultime étape consistant à :
- pour la ou les X dernière(s) phase(s) de traitement, avec X ≥ 1 : conserver les caractéristiques optimales de transposition et de filtrage, propres à chaque phase de traitement ;
- pour chacune des L-X premières phases de traitement, avec L le nombre total de phases de traitement et L-X ≥ 2 : remplacer les caractéristiques optimales de transposition et de filtrage, propres à chaque phase de traitement, par des caractéristiques de transposition et de filtrage communes, et égales à celles de la L-X^{ème} phase de traitement.

15. Démodulateur numérique, du type comprenant au moins une chaîne de démodulation monocanal (4), caractérisé en ce que chaque chaîne (4) comprend un dispositif (6) de filtrage, décimation et transposition en bande de base selon l'une quelconque des revendications 1 à 11.
